# EUROPÄISCHE PATENTSCHRIFT

(11) **EP 0 604 925 B1**
(45) Veröffentlichungstag und Bekanntmachung des Hinweises auf die Patenterteilung: **16.10.1996**
(21) Anmeldenummer: 93120862.3
(22) Anmeldetag: 24.12.1993
(51) Int. Cl.: F24F 3/16

(54) **Verfahren zur Luftführung in einem Aufnahmeraum sowie Vorrichtung zum Bearbeiten von Kleinteilen**
Method of circulating air in a compartment and device for handling small objects
Procédé pour la conduite d'air dans un compartiment et dispositif pour le traitement de petites pièces

(30) Priorität: 31.12.1992 DE 9217873 U
(43) Veröffentlichungstag der Anmeldung: 06.07.1994
(73) Patentinhaber: Metall + Plastic GmbH, D-78315 Radolfzell (DE)
(72) Erfinder: Bertsche, Thomas, D-78239 Rielasingen-W. 2 (DE); von Stenglin, Christoph, D-78315 Radolfzell (DE); Springmeier, Ewald, D-42117 Wuppertal (DE)
(74) Vertreter: Hiebsch, Gerhard F., Dipl.-Ing.

(56) Entgegenhaltungen:
- GB-A- 2 147 409
- PATENT ABSTRACTS OF JAPAN vol. 10, no. 249 (M-511) (2305) 27. August 1986 & JP-A-61 076 837 (SHINKO KOGYO) 19. April 1986

## Beschreibung

Die Erfindung betrifft ein Verfahren zur Luftführung in einem Aufnahmeraum mit einer -- insbesondere etwa rechteckigen -- Fläche für Behandlungsgüter. Zudem erfaßt die Erfindung eine Vorrichtung zum Bearbeiten oder Manipulieren von Kleinteilen auf jener Fläche unter Reinraumbedingungen.

Für die Behandlung von Kleinstteilen -- beispielsweise von Produkten der Pharmaindustrie, der Uhrenindustrie oder der Computertechnik -- werden immer höhere Anforderungen an die Raumkonditionen, insbesondere die Raumreinheit, gestellt. Die üblichen Reinräume haben sich als Produktionsstätten mit Schleusentüren für das Personal in vielen Fällen als mangelhaft erwiesen, vor allem dann, wenn die Personalbewegung zu ungünstigen Strömungsverhältnissen im Arbeitsraum führt.

Die Schrift zum DE-GM 1 821 926 beschreibt einen druckfesten Stahlkessel als Prüfkammer für Baustoffe mit innerhalb des Kessels verlaufenden horizontalen Luftführungen, durch welche Luft in den Prüfraum seitlich eingeführt und an dessen Rückseite entnommen wird. Dabei entstehen zwei horizontale Luftkreisläufe, welche sich in der Prüfkammer berühren. Eine Verbesserung der Bedingungen für Reinräume vermag dieser Stahlkessel nicht anzubieten.

Bekannt sind zudem offene Laborkabinen mit perforierter Tischfläche, durch welche die Abluft nach unten abgesaugt wird.

In Kenntnis dieses Standes der Technik hat sich der Erfinder das Ziel gesetzt, eine verbesserte Luftführung für Reinräume zu schaffen und insbesondere eine Vorrichtung, mit der unter besonders günstigen Bedingungen in Reinraumatmosphäre gearbeitet zu werden vermag.

Zur Lösung dieser Aufgabe führen die Lehren der unabhängigen Ansprüche, die Unteransprüche geben weitergehende Ausgestaltungen an.

Erfindungsgemäß soll die Luft von oben her auf die Fläche des gegen die Umgebung dicht verschlossenen Aufnahmeraumes geführt und oberhalb der Fläche zu ihren Randbereichen umgelenkt werden, an denen die Luft dann durch von den Randbereichen begrenzte Leitungsräume abgeführt wird. Als Leitungsräume sollen durchgehende Strömungsquerschnitte eingesetzt und zudem die Luft zumindest an den Längskanten der Fläche über deren gesamte Länge hin gleichmäßig abgesaugt werden.

Nach einem weiteren Merkmal der Erfindung ist die Luft zumindest an der Fläche und im Manipulationsbereich über dieser laminar geführt.

Dank dieser Verfahrensweise erreicht man oberhalb der Fläche, auf welcher die zu behandelnden Teile aufliegen, eine besonders ruhige Luftführung, die es ermöglicht, auch sehr leichte und kleine Teile ohne Luftbeeinflussung zu bearbeiten oder zu manipulieren.

Auch hat es sich als günstig erwiesen, die Luft der Arbeitsfläche konditioniert zukommen zu lassen, sie beispielsweise anzuwärmen oder aber mit besonderen Behandlungsmitteln zu befrachten, welche in Abhängigkeit von dem jeweiligen Arbeitsprozeß der Luft beigemischt werden.

Eine Vorrichtung der eingangs erwähnten Art, die sich zur Anwendung des beschriebenen Verfahrens besonders eignet, zeichnet sich dadurch aus, daß die als geschlossener Arbeitstisch ausgebildete Fläche von einem doppelwandigen Gehäuse dicht umgeben ist, das an Flächenkanten Strömungsquerschnitte bildet, wobei oberhalb der Fläche und in Abstand zu ihr ein dieser gleichmäßig verteilt Luft zuführender Strömungsraum angeordnet ist.

Parallel zu den erwähnten Flächenkanten oder Randbereichen verlaufen in verhältnismäßig geringem Abstand Umlenkkanten der als Trennscheibe ausgebildeten Innenwand des doppelwandigen Gehäuses. Diese Umlenkkante kann zur Feineinstellung der Strömung sogar -- in Grenzen -- höhenverstellbar konzipiert werden.

Vorteilhafterweise wird das Gehäuse an seinen Gehäuselängswänden mit zumindest einem Sichtfenster und dieses sowie den Strömungsquerschnitt durchsetzenden Manipulationsstrümpfen od.dgl. flexiblen Eingriffsorganen ausgestattet; der Gehäuselängswand soll zudem eine wenigstens im Bereich des Sichtfensters transparente Trennscheibe vorgeordnet sein, die mit der Gehäuselängswand dem Strömungsquerschnitt begrenzt und bevorzugt im Gehäuseinnenraum sowie in einem Spaltabstand von der Fläche verläuft.

Angesichts des Wunsches nach einer einfachen und kompakten Reinstraumstation wird die Fläche -- wie angedeutet -- als eine mit Förderelementen versehene Tischfläche gestaltet, die von außen her über die Manipulationsstrümpfe erreichbar ist und an deren Kanten jeweils durchgehende Strömungsquerschnitte verlaufen; insbesondere soll die Tischfläche rundum ein Strömungsquerschnitt umgeben. So entsteht eine brauchbare Arbeitsstation, insbesondere eine Abfüllanlage für Pillen od.dgl. Pharmazeutika, welche den aufgabengemäßen Auflagen Rechnung trägt.

Um die Konzeption der Baueinheit zu verbessern, soll dem Luft zuführenden Strömungsraum in Strömungsrichtung ein Lüfter vorgeordnet und dieser in einem dem Gehäuseinnenraum überlagernden Lüftergehäuse angebracht sein; den Lüfter unterfängt eine Luftleitplatte, diese wiederum eine die Luft verteilende Rostplatte als tischseitiger Abschluß des Strömungsraumes.

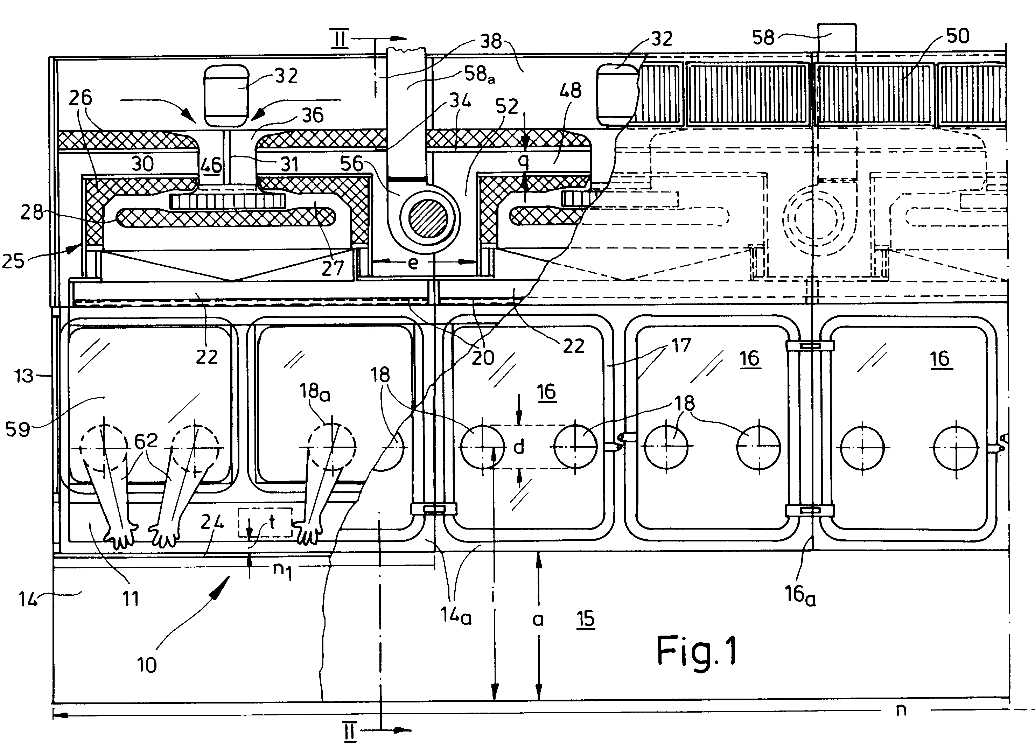

Weitere Vorteile, Merkmale und Einzelheiten der Erfindung ergeben sich aus der nachfolgenden Beschreibung eines bevorzugten Ausführungsbeispieles sowie anhand der Zeichnung; diese zeigt in
- Fig. 1:: die teilweise geschnittene Seitenansicht eines Abschnittes einer Abfüllstraße;
- Fig. 2:: den Querschnitt durch Fig. 1 nach deren Linie II-II;
- Fig. 3:: die Draufsicht auf einen Teil der Abfüllstraße gemäß Schnittlinie III-III in Fig. 1.

Eine Abfüllstraße 10 zur Manipulation mit Klein- und Kleinststeilen in Reinstraumatmosphäre weist ein luftdichtes quaderförmiges Gehäuse 12 mit -- im gewählten Ausführungsbeispiel -- einer Länge n von 550 cm, einer Höhe h von 300 cm und einer Breite b von 120 cm auf, in welchem an jeder der Gehäuselängswände 14 Sichtfenster 16 vorgesehen sind. Die Gehäuselängswände 14 bestehen jeweils aus einer durchgehenden Sockelplatte 15 der Höhe a von 70 cm und auf diese aufgesetzten Wandabschnitten 14a der Länge nl mit zwei Sichtfenstern 16. Auch die Gehäusestirnwände 13 des Gehäuses 12 kann mit Sichtfenstern 16 ausgestattet sein.

Jedes der Sichtfenster 16 ist mit zumindest einer Ausnehmung 18 kreisförmiger Kontur und dieser umgebender Ringmanschette 19 versehen, deren Durchmesser d etwa 25 cm und deren mittlerer Bodenabstand i etwa 120 cm messen. Ein Rahmen 17, der das um eine Achse 16a klappbar eingesetzte, dicht schließende Sichtfenster 16 umgibt, endet nach oben hin nahe einer Rostplatte 20 als Unterdecke für einen horizontalen Zuluftkanal 22; mehrere dieser Rostplatten 20 begrenzen einen -- Fördermittel od. dgl. aufnehmenden -- Abfüllrahmen 11 nach oben, der anderseits untehalb des Rahmens 17 an einer horizontalen Tischplatte 24 endet.

Der Zuluftkanal 22 unterfährt ein Lüftergehäuse 25 mit Dämmbekleidung 26 für ein sich über einer die Luft verteilenden Leitplatte 28 drehendes Lüfterrad 30. Dessen Lüfterantrieb 32 liegt oberhalb einer Deckplatte 34 mit zentrischem Durchbruch 36 für die Lüfterachse 31 in einem Kopfraum 38; letzterer wird von einer Deckenplatte 40 des Gehäuses 12 überspannt, die gemäß Fig. 5 mit einer Raumdecke 42 durch eine vertikale Blende 44 verbunden sein kann.

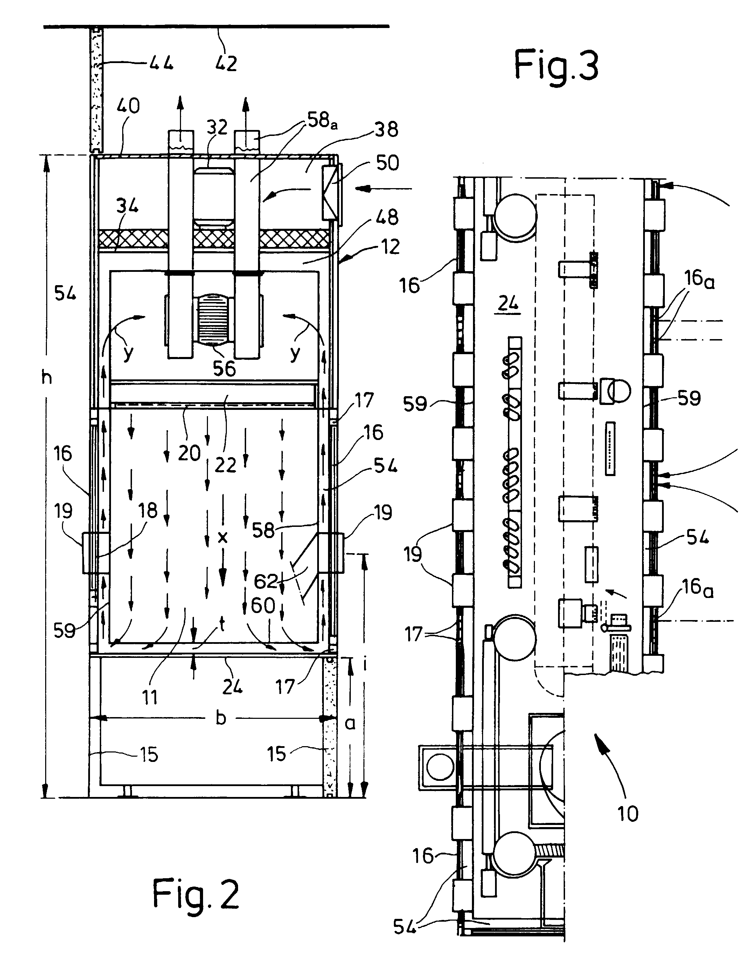

Im Durchbruch 36 ist eine Rohrauskleidung 46 angebracht, welche einen -- zwischen Lüftergehäuse 25 und Deckplatte 34 bestehenden -- Zwischenraum 48 der Höhe q von etwas mehr als 10 cm durchgreift und innerhalb des Lüftergehäuses 24 endet. Das Lüfterrad 30 zieht durch in der Gehäuselängswand 12 oberhalb der Deckplatte 34 vorgesehene Filterplatten 50 Luft in den Kopfraum 38, welche durch die Rohrauskleidung 46 in den von Lüftergehäuse 25 und Leiterplatte 28 begrenzten Spaltraum 27 gelangt sowie von diesem in den Zuluftkanal 22. Von dort fällt die Luft gemäß Pfeil x in Fig. 2 abwärts zur Tischplatte 24.

Mehrere der erwähnten Ziwschenräume 48 bilden mit jeweils zwischen zwei in Abstand e benachbarten Lüftergehäusen 25 angeordneten Lufträumen 52 einen Luftführungskanal für Abluft. Diese wird von der Tischplatte 24 in einen Strömungsquerschnitt 54 der Gehäuselängswand 14 -- und entsprechend auch der Gehäusestirnwand 13 -- gezogen und steigt in diesem zu jenem Luftführungskanal 48/52 auf. Sie gelangt innerhalb des Luftraumes 52 zu einem Ventilator 56 und wird in vertikalen Abluftrohren 58 über die Deckenplatte 40 ausgetragen.

Der Strömungsquerschnitt 54 wird nach außen von der beschriebenen Gehäuselängswand 14 -- bzw. der Gehäusestirnwand 13 -- mit ihren Sichtfenstern 16 begrenzt und zum Abfüllraum 11 hin durch eine transparente Trennscheibe 59, die ihrerseits an die Ringmanschette 19 angeschlossene Ausnehmungen 18a aufweist und in deren untere Umlenkkante 60 in einem etwa 100 mm messenden Spaltabstand t von der Tischplatte 24 endet. Innenseitig setzt sich die Ringmanschette 19 in einem flexiblen luftdichten Ärmelhandschuh 62 aus transluzentem Werkstoff als Manipulationsstrumpf fort.

Im Abfüllraum 11 wird durch die in seinem Querschnitt fallende -- vorkonditionierte -- Luft auf der Tischplatte 24 jede Turbulenz vermieden. Die auf der geschlossenen Tischplatte 24 bzw. den Fördermitteln befindlichen Kleinteile werden von außen her in laminaren Strömungsverhältnissen gehandhabt; dank der beschriebenen Luftführung entstehen nahezu ideal wirbelfreie Strömungen, für welche die Bernoullische Gleichung gilt, für die ausströmende Luft (Pfeil y in Fig. 2) das Torricellische Ausflußgesetz entsprechend.

## Patentansprüche

1. Verfahren zur Luftführung in einem gegen die Umgebung dicht verschlossenen Aufnahmeraum mit einer inbesondere rechteckigen Fläche für Behandlungsgüter, bei dem die Luft von oben her auf die Fläche geführt und oberhalb der Fläche abgeleitet sowie zu den Randbereichen des Aufnahmeraumes umgelenkt wird, an denen die Luft durch von den Randbereichen begrenzte Leitungsräume abgeführt wird.

2. Verfahren nach Anspruch 1, dadurch gekennzeichnet, daß die Luft zumindest an den Längskanten der Fläche über deren gesamte Länge gleichmäßig abgeführt wird.

3. Verfahren nach Anspruch 1 oder 2, gekennzeichnet durch eine laminare Strömung der Luft an der Fläche.

4. Verfahren nach einem der Ansprüche 1 bis 3, dadurch gekennzeichnet, daß die Luft vor ihrer Zuführung zur Fläche konditioniert, insbesondere erwärmt, und/oder daß die Luft vor ihrer Zuführung mit Zusätzen vermischt wird.

5. Vorrichtung zum Bearbeiten oder Manipulieren von Kleinteilen, gemäß dem Verfahren nach wenigstens einem der voraufgehenden Ansprüche, mit einer von oben her aus einem Strömungsraum mit Luft versorgten geschlossenen Fläche (24), die von einem doppelwandigen Gehäuse (12) unter Reinraumbedingungen dicht umgeben ist, welches an Flächenkanten durchgehende Strömungsquerschnitte (54) bildet.

6. Vorrichtung nach Anspruch 5, dadurch gekennzeichnet, daß der Gehäusewand (13, 14) eine Trennscheibe (59) vorgeordnet ist, die mit ihr den Strömungsquerschnitt (54) begrenzt, wobei bevorzugt die Trennscheibe (59) an der Gehäusewand (13, 14) im Gehäuseinnenraum (11) verläuft und in einem Spaltabstand (t) von der Fläche (24) eine Umlenkkante (60) bildet.

7. Vorrichtung nach Anspruch 6, dadurch gekennzeichnet, daß die Umlenkkante (60) begrenzt höhenverstellbar ausgebildet ist.

8. Vorrichtung nach einem der Ansprüche 5 bis 7, dadurch gekennzeichnet, daß die Tischfläche (24) rundum von dem Strömungsquerschnitt (54) umgeben ist.

9. Vorrichtung nach einem der Ansprüche 5 bis 8, dadurch gekennzeichnet, daß dem Luft zuführenden Strömungsraum (22) in Strömungsrichtung (x) ein in einem dem Gehäuseinnenraum (11) überlagernden Lüftergehäuse (25) angebrachter Lüfter (30) vorgeordnet ist, und/oder daß der Lüfter (30) an einem Kopfraum (38) mit Luftzugängen angeschlossen ist, welche Konditioniereinsätze (50) aufweisen.

10. Vorrichtung nach wenigstens einem der Ansprüche 5 bis 9, dadurch gekennzeichnet, daß die Bodenplatte des Kopfraumes (38) Deckplatte (34) eines Luftraumes (48, 52) für die ausziehende Luft (y) ist, der anderseits vom Lüftergehäuse (25) begrenzt ist, und/oder, daß zwischen benachbarten Lüftergehäusen (25) im Luftraum (52) ein Ventilator (56) angeordnet ist.

11. Vorrichtung nach wenigstens einem der Ansprüche 5 bis 10, dadurch gekennzeichnet, daß das Gehäuse (12) an seinen Gehäusewänden (13, 14) mit zumindest einem Sichtfenster (16) und dieses sowie den Strömungsquerschnitt (54) durchsetzenden Manipulationsstrümpfen od.dgl. flexiblen Eingriffsorganen versehen ist, wobei die Trennscheibe (59) wenigstens im Bereich des Sichtfensters transparent ist.

12. Vorrichtung nach wenigstens einem der Ansprüche 5 bis 11, dadurch gekennzeichnet, daß die Fläche eine mit Förderelementen versehene Tischfläche (24) ist, an deren Kanten jeweils durchgehende Strömungsquerschnitte (54) verlaufen.

## Claims

1. Method of circulating air in a compartment sealed off from the surroundings with an in particular rectangular surface for material being treated, in which the air is guided on to the surface from above and diverted upwards from the surface and deflected towards the edge regions of the compartment, where the air is carried away via lines delimited by the edge regions.

2. Method according to claim 1, characterised in that the air is carried away at least at the longitudinal edges of the surface in a uniform manner over the entire length thereof.

3. Method according to claim 1 or claim 2, characterised by a laminar flow of the air at the surface.

4. Method according to one of claims 1 to 3, characterised in that the air is conditioned, in particular heated, before it is fed to the surface and/or that the air is mixed with additives before the feeding thereof.

5. Device for treating or handling small parts according to the method according to at least one of the preceding claims, comprising a closed surface (24) supplied from above with air from a flow space, said surface being surrounded in a sealed manner under clean air conditions by a double-walled housing (12) forming continuous flow channels (54) at edges of the surface.

6. Device according to claim 5, characterised in that a baffle plate (59) is arranged in front of the housing wall (13, 14) and delimits the flow channel (54) together therewith, the baffle plate (59) preferably extending along the housing wall (13, 14) in the interior (11) of the housing and forming a guide edge (60) at a distance (t) from the surface (24).

7. Device according to claim 6, characterised in that the guide edge (60) is vertically adjustable to a limited extent.

8. Device according to one of claims 5 to 7, characterised in that the table surface (24) is surrounded all round by the flow channel (54).

9. Device according to one of claims 5 to 8, characterised in that a fan (30) mounted in a fan housing (25) superimposed upon the interior (11) of the housing is arranged in front of the flow space (22) supplying air in the flow direction (x) and/or that the fan (30) is connected to a headspace (38) with air inlets having conditioning cartridges (50).

10. Device according to at least one of claims 5 to 9, characterised in that the bottom plate of the headspace (38) is the cover plate (34) of an air space (48, 52) for the emergent air (y), delimited at the other end by the fan housing (25), and/or that a ventilator (56) is arranged in the air space (52) between adjacent fan housings (25).

11. Device according to at least one of claims 5 to 10, characterised in that the housing (12) is provided on its housing walls (13, 14) with at least one viewing window (16) and handling stockings or similar flexible operating members traversing the viewing window and the flow channel (54), the baffle plate (59) being transparent at least in the region of the viewing window.

12. Device according to at least one of claims 5 to 11, characterised in that the surface is a table surface (24) provided with conveyor elements, along the edges of which continuous flow channels (54) extend.

## Revendications

1. Procédé pour le guidage d'air dans une chambre de réception fermée de façon étanche par rapport à l'environnement, comportant une surface en particulier rectangulaire pour des biens à traiter, dans lequel l'air est guidé depuis le haut sur la surface et est évacué au-dessus de la surface et renvoyé jusqu'aux régions marginales de la chambre de réception, au niveau desquelles l'air est évacué à travers des chambres de guidage délimitées par les régions marginales.

2. Procédé selon la revendication 1, caractérisé en ce que l'air est évacué de façon régulière au moins le long des arêtes longitudinales de la surface sur toute leur longueur.

3. Procédé selon l'une ou l'autre des revendications 1 et 2, caractérisé par un écoulement laminaire de l'air au niveau de la surface.

4. Procédé selon l'une quelconque des revendications 1 à 3, caractérisé en ce que l'air est conditionné, en particulier réchauffé avant son amenée vers la surface, et/ou en ce que l'air est mélangé avec des additifs avant son amenée.

5. Dispositif pour traiter ou manipuler de petites pièces, conformément au procédé selon l'une quelconque au moins des revendications précédentes, comportant une surface fermée (24) qui est alimentée en air depuis le haut par une chambre d'écoulement et qui est entourée de façon étanche par un boîtier (12) à paroi double sous des conditions de salle blanche, ce boîtier formant des sections transversales d'écoulement (54) continues le long des arêtes de surface.

6. Dispositif selon la revendication 5, caractérisé en ce qu'il est prévu en amont de la paroi de boîtier (13, 14) un disque de séparation (59) qui délimite avec celle-ci la section transversale d'écoulement (54), et le disque de séparation (59) s'étend de préférence le long de la paroi de boîtier (13, 14) dans la chambre intérieure de boîtier (11) et forme une arête de renvoi (60) à une distance (t) de la surface (24).

7. Dispositif selon la revendication 6, caractérisé en ce que l'arête de renvoi (60) est réalisée de manière réglable en hauteur à l'intérieur de certaines limites.

8. Dispositif selon l'une quelconque des revendications 5 à 7, caractérisé en ce que la surface de tablier (24) est entourée tout autour par la section transversale d'écoulement (54).

9. Dispositif selon l'une quelconque des revendications 5 à 8, caractérisé en ce qu'il est prévu, en direction d'écoulement (x), en amont de la chambre d'écoulement (22) qui amène l'air, un ventilateur (30) agencé dans un boîtier de ventilateur (25) recouvrant la chambre intérieure de boîtier (11), et/ou en ce que le ventilateur (30) est raccordé à une chambre de tête (38) présentant des accès d'air qui comprennent des inserts de conditionnement (50).

10. Dispositif selon l'une quelconque au moins des revendications 5 à 9, caractérisé en ce que la plaque de fond de la chambre de tête (38) représente la plaque de recouvrement (34) d'une chambre à air (48, 52) pour l'air sortant (y), qui est délimitée par ailleurs par le boîtier de ventilateur (25), et/ou en ce qu'il est prévu un ventilateur (56) entre des boîtiers de ventilateur voisins (25) dans la chambre à air (52).

11. Dispositif selon l'une quelconque au moins des revendications 5 à 10, caractérisé en ce que le boîtier (12) est pourvu au niveau de ses parois de boîtier (13, 14) d'au moins une fenêtre d'observation (54) et de gants de manipulation ou d'organes d'intervention flexibles similaires qui traversent ladite fenêtre d'observation et la section transversale d'écoulement (54), le disque de séparation (59) étant transparent au moins dans la région de la fenêtre d'observation.

12. Dispositif selon l'une quelconque au moins des revendications 5 à 11, caractérisé en ce que la surface représente une surface de tablier (24) pourvue d'éléments de convoyage, et le long des arêtes de cette surface s'étendent respectivement des sections transversales d'écoulement continues (54).
